# EUROPÄISCHE PATENTSCHRIFT

(11) **EP 3 365 926 B1**
(45) Veröffentlichungstag und Bekanntmachung des Hinweises auf die Patenterteilung: **20.10.2021**
(21) Anmeldenummer: 16797453.4
(22) Anmeldetag: 20.10.2016
(51) Int. Cl.: H01L 41/04, H02N 2/06

(54) **VERFAHREN ZUR ANSTEUERUNG EINES ELEKTROMECHANISCHEN ELEMENTS**
METHOD FOR ACTIVATING AN ELECTROMECHANICAL ELEMENT
PROCÉDÉ DE COMMANDE D'UN ÉLÉMENT ÉLECTROMÉCANIQUE

(30) Priorität: 20.10.2015 DE 102015013553
(43) Veröffentlichungstag der Anmeldung: 29.08.2018
(73) Patentinhaber: Physik Instrumente (PI) GmbH & Co. KG, 76228 Karlsruhe (DE)
(72) Erfinder: MARTH, Harry, 76337 Waldbronn (DE); REISER, Jonas, 76337 Waldbronn (DE)
(74) Vertreter: Schatt, Markus F.
(86) Internationale Anmeldenummer: PCT/DE2016/100490
(87) Internationale Veröffentlichungsnummer: WO 2017/067544

(56) Entgegenhaltungen:
- JP-A- S 611 278
- US-B2- 8 138 658
- KUSHNIR U ET AL: "Advanced piezoelectric-ferroelectric stack actuator", SENSORS AND ACTUATORS A: PHYSICAL, ELSEVIER BV, NL, Bd. 150, Nr. 1, 16. März 2009 (2009-03-16) , Seiten 102-109, XP025959099, ISSN: 0924-4247, DOI: 10.1016/J.SNA.2008.11.036 [gefunden am 2009-02-23]

## Beschreibung

Die Erfindung betrifft ein Verfahren zur Ansteuerung wenigstens eines Abschnitts eines elektromechanischen Elements.

In der JP 61-1278 wird ein Umschalten zwischen dem voll polarisierten und dem nicht polarisierten Zustand eines elektromechanischen Elements beschrieben. In der Veröffentlichung von U.Kushnir und O.Rabinovitch "Sensors and Actuators" A 150 (2009), Seiten 102 bis 109, mit Bezugnahme auf weiteren Stand der Technik wird das Materialverhalten bei einem Umschalten zwischen dem voll polarisierten und dem nicht polarisierten Zustand eines elektromechanischen Elements beschrieben. Aus der US 8,138,658 B2 ist ein Aktuator mit mehreren Lagen eines piezoelektrisch-ferroelektrischen Materials bekannt, bei dem gezielt an einzelne Lagen ein definiertes elektrisches Feld anlegbar ist, um dort den nichtlinearen Effekt des ferroelektrischen Anteils durch Überführen von einem komplett unpolarisierten Domänenzustand in einen komplett polarisierten Domänenzustand oder umgekehrt, d. h. durch ein Domänenumklappen, auszunutzen. Durch besagtes Domänenumklappen können diskontinuierliche Deformationsänderungen, d. h. Deformationssprünge, in diesen Lagen erzielt werden, während die Ausnutzung des piezoelektrischen Effekts in den übrigen Lagen des Aktuators zu einer linearen und kontinuierlichen Deformationsänderung führt. Insgesamt ergibt sich hierdurch ein Aktuator mit einem erweiterten Stellwegbereich. Ein weiterer Vorteil liegt darin, dass die durch Domänenumklappen generierten Deformationen des Aktuators auch ohne Anlegen einer äußeren Spannung bestehen bleiben.

Nachteilig an dem aus der US 8,138,658 B2 bekannten Aktuator ist das Generieren von Deformationssprüngen, so dass dieser Aktuator für sehr feine Stellbewegungen nicht bzw. nur mit sehr hohem Ansteuerungsaufwand verwendbar ist.

Der Erfindung liegt somit die Aufgabe zugrunde, ein Verfahren zur Ansteuerung wenigstens eines Abschnitts eines elektromechanischen Elements, nämlich eines Änderungsabschnitts, bereitzustellen, welches dieses für sehr feine und definierte Stellbewegungen geeignet macht, wobei die durch Anlegen von elektrischen Feldern erzeugten Deformationen des Änderungsabschnitts auch nach Wegnahme der entsprechenden elektrischen Felder bestehen bleiben.

Diese Aufgabe wird gelöst durch das Verfahren nach Anspruch 1, wobei die sich daran anschließenden Unteransprüche mindestens zweckmäßige Weiterbildungen darstellen.

Demgemäß wird ausgegangen von einem Verfahren zur Ansteuerung wenigstens eines Abschnittes eines elektromechanischen Elements, wobei der entsprechende Abschnitt einen Änderungsabschnitt definiert. Es sei an dieser Stelle betont, dass der Änderungsabschnitt auch das komplette elektromechanische Element umfassen kann. Mit anderen Worten schließt die Erfindung ein, dass das komplette elektromechanische Element dem Änderungsabschnitt entspricht, und das komplette elektromechanische Element nach dem erfindungsgemäßen Verfahren angesteuert wird.

Das erfindungsgemäße Verfahren umfasst hierbei folgende Schritte: Bereitstellen eines elektromechanischen Elements als Stellelement, wobei bei dem elektromechanischen Element zumindest der Änderungsabschnitt wenigstens zwei voneinander beabstandeten Elektroden und ein zwischen den Elektroden angeordneten polykristallinen und ferroelektrischen oder ferroelektrisch- piezoelektrischen Material mit einer Vielzahl von Domänen aufweist, wobei in einem Ausgangszustand zumindest ein Teil der Domänen voneinander abweichende Polarisationsrichtungen aufweist; Erzeugung eines elektrischen Feldes zwischen den Elektroden des Änderungsabschnitts durch Anlegen einer elektrischen Spannung in Form wenigstens eines Spannungspulses mit einer definierten Amplitude und einer definierten Dauer und einer bleibenden Änderung des Polarisationsgrads des Änderungsabschnitts in Abhängigkeit der Amplitude und der Dauer des Spannungspulses für eine kontrollierte bleibende Ausdehnungsänderung des Änderungsabschnitts des Stellelements mit: Überführen eines Teils der Domänen mit voneinander abweichenden Polarisationsrichtungen in einen Zustand gleicher Polarisationsrichtung aufgrund des wenigstens einen Spannungspulses und dadurch Erzeugen einer definierten und ohne das Vorhandensein einer elektrischen Spannung verbleibenden Zunahme der Ausdehnung des Änderungsabschnitts des elektromechanischen Elements entlang einer Ausdehnungsrichtung V oder Überführen eines Teils der Domänen mit gleicher Polarisationsrichtung in einen Zustand mit voneinander abweichenden Polarisationsrichtungen aufgrund des wenigstens einen Spannungspulses und dadurch Erzeugen einer definierten und ohne das Vorhandensein einer elektrischen Spannung verbleibenden Abnahme der Ausdehnung des Änderungsabschnitts des elektromechanischen Elements entlang der Ausdehnungsrichtung V.

Der im Vorstehenden verwendete Begriff ,elektromechanisches Element' bezieht sich hierbei im allgemeinsten Sinne auf ein Element, bei dem aufgrund des Einwirkens einer elektrischen Spannung bzw. dem Einwirken eines elektrischen Feldes eine mechanische Reaktion, etwa eine Ausdehnungsänderung, die ihrerseits beispielsweise für eine Stellbewegung nutzbar ist, hervorrufbar ist. Gleichzeitig bezieht sich der Begriff im allgemeinsten Sinne auf ein Element, bei welchem in umgekehrter Weise ein mechanisches Einwirken, beispielsweise das Aufbringen einer Druckkraft, die Erzeugung eines elektrischen Feldes bzw. einer elektrischen Spannung bewirkt.

Der im Vorstehenden verwendete Begriff 'Domäne' bezeichnet einen Bereich eines polykristallinen und ferroelektrischen bzw. ferroelektrisch-piezoelektrischen Materials, in welchem eine identische oder nahezu identische Polarisationsrichtung vorhanden ist.

Der Im Vorstehenden bezeichnete Begriff ,Ausdehnungsrichtung V' beschreibt die Richtung der betragsmäßig größten und für den spezifischen Anwendungsfall nutzbaren Ausdehnung des elektromechanischen Elements.

Durch den wenigstens einen Spannungspuls wird - abhängig von der Amplitude und der Dauer des Spannungspulses - bei einem kleineren oder größeren Teil der Domänen der Polarisationszustand bleibend verändert, so dass entsprechende definierte und bleibende Deformationsänderungen des Änderungsabschnitts des elektromechanischen Elements resultieren. Werden hierbei die entsprechenden Domänen mit unterschiedlicher Polarisationsrichtung in einen Zustand gleicher Polarisationsrichtung überführt, so ergibt sich eine vergrößerte Ausdehnung des Änderungsabschnitts des elektromechanischen Elements entlang der Ausdehnungsrichtung V, während die Überführung von Domänen mit gleicher Polarisationsrichtung in einen Zustand unterschiedlicher Polarisationsrichtung zu einer Abnahme der Ausdehnung des Änderungsabschnitts des elektromechanischen Elements entlang der Ausdehnungsrichtung V führt.

Es kann von Vorteil sein, dass die Dauer eines Spannungspulses zwischen 50 und 150ms, und bevorzugt zwischen 70 und 120ms beträgt.

Hierbei kann es von Vorteil sein, dass die Dauer des Anstiegsabschnitts eines Spannungspulses und die Dauer des Abfallabschnitts eines Spannungspulses zwischen 5 und 20ms, und bevorzugt zwischen 8 und 12ms beträgt.

Es kann auch von Vorteil sein, dass nach dem Schritt des Bereitstellens eines elektromechanischen Elements und vor dem Schritt der Erzeugung eines elektrischen Feldes zwischen den Elektroden des Änderungsabschnitts durch Anlegen einer elektrischen Spannung in Form wenigstens eines Spannungspulses ein zusätzlicher Verfahrensschritt zur Erzeugung einer definierten Anfangsausdehnung des Änderungsabschnitts ausgeführt wird, bei welchem eine solche elektrische Spannung bzw. solche elektrische Spannungen an die Elektroden des Änderungsabschnitts angelegt wird bzw. werden, wonach eine maximale Ausdehnungszunahme entsprechend einem Polarisationsgrad von 100% und/oder eine maximale Ausdehnungsabnahme entsprechend einem Polarisationsgrad von 0% des Änderungsabschnitts resultieren/resultiert, wobei der Unterschied zwischen der maximalen Ausdehnungszunahme und der maximalen Ausdehnungsabnahme den maximal möglichen Ausdehnungsänderungsbereich definiert.

Es kann daneben von Vorteil sein, dass bei einer beabsichtigen Ausdehnungsänderung von weniger als 50% des maximalen Ausdehnungsänderungsbereichs eine solche elektrische Spannung an die Elektroden des Änderungsabschnitts angelegt wird, dass ein Polarisationsgrad von 0% resultiert, und bei einer beabsichtigten Ausdehnungsänderung von mehr als 50% des maximalen Ausdehnungsänderungsbereichs eine solche elektrische Spannung an die Elektroden des Änderungsabschnitts angelegt wird, dass ein Polarisationsgrad von 100% resultiert.

Es kann weiterhin von Vorteil sein, dass ein elektromechanisches Element bereitgestellt wird, bei dem in dem Ausgangszustand das Material des Änderungsabschnitts einen Polarisationsgrad zwischen 40% und 60%, und besonders bevorzugt einen Polarisationsgrad von 50% aufweist. Mit Polarisationsgrad ist hierbei der Anteil der Domänen des Materials des Änderungsabschnitts des elektromechanischen Elements bezeichnet, welche eine gleiche Polarisationsrichtung aufweisen. Durch die entsprechende Polarisation des Materials des Änderungsabschnitts des elektromechanischen Elements in seinem Ausgangszustand ist es möglich, bereits aus dem Ausgangszustand heraus durch Verringerung der Anzahl an Domänen gleicher Polarisationsrichtung eine Abnahme der Ausdehnung des Änderungsabschnitts des elektromechanischen Elements entlang der Ausdehnungsrichtung V zu realisieren.

Zudem kann es von Vorteil sein, dass die Amplitude der Spannungspulse für eine definierte Zunahme der Ausdehnung des Änderungsabschnitts des elektromechanischen Elements entlang der Ausdehnungsrichtung V so bemessen ist, dass eine resultierende elektrische Feldstärke zwischen benachbarten Elektroden zwischen 50% und 200% der Koerzitivfeldstärke beträgt. Hierbei kann die entsprechende Amplitude umso kleiner bemessen sein, je größer die Dauer und/oder je größer die Anzahl der aufgebrachten Spannungsimpulse ist, und umgekehrt kann die entsprechende Amplitude umso größer bemessen sein, je kleiner die Dauer und/oder die Anzahl der der aufgebrachten Spannungsimpulse ist. Mit Koerzitivfeldstärke ist die Feldstärke gemeint, die ausreichend ist, um entweder alle Dipolmomente der Domänen eines ferroelektrischen Materials in Feldrichtung auszurichten (Sättigungspolarisation) oder um die Polarisation auf Null zu verringern.

Ferner kann es von Vorteil sein, dass die Amplitude der Spannungspulse für eine definierte Abnahme der Ausdehnung des Änderungsabschnitts des elektromechanischen Elements entlang der Ausdehnungsrichtung V so bemessen ist, dass die resultierende elektrische Feldstärke zwischen benachbarten Elektroden zwischen 10% und 90% der Koerzitivfeldstärke beträgt. Auch hierbei kann die entsprechende Amplitude umso kleiner bemessen sein, je größer die Dauer und/oder je größer die Anzahl der aufgebrachten Spannungsimpulse ist, und umgekehrt kann die entsprechende Amplitude umso größer bemessen sein, je kleiner die Dauer und/oder die Anzahl der der aufgebrachten Spannungsimpulse ist.

Außerdem kann es von Vorteil sein, dass einem ersten Spannungspuls ein zweiter Spannungspuls folgt, wobei der zweite Spannungspuls eine zu dem ersten Spannungspuls unterschiedliche Polarität aufweist.

Darüber hinaus kann es von Vorteil sein, dass sich die Amplitude des zweiten Spannungspulses von der Amplitude des ersten Spannungspulses unterscheidet, und bevorzugt die Amplitude des zweiten Spannungspulses betragsmäßig kleiner als die Amplitude des ersten Spannungspulses ist.

Es kann von Vorteil sein, dass zwischen dem mit dem erfindungsgemäßen Verfahren angesteuerten elektromechanischen Element und einem durch das elektromechanische Element zu bewegenden Element ein weiteres elektromechanisches Element, vorzugsweise ein piezoelektrischer Aktor, angeordnet ist. Ebenso ist jedoch denkbar, dass ein elektromechanisches Element zwei unterschiedliche Abschnitte aufweist, wovon einer der Änderungsabschnitt ist, der nach dem erfindungsgemäßen Verfahren angesteuert wird, während der verbleibende Teil - welcher dann dem weiteren elektromechanischen Element bzw. dem piezoelektrischen Aktor im Sinne des Vorstehenden entspricht - einen herkömmlichen Aktor darstellt.

Es zeigen:
Fig. 1: Versuchsaufbau zur Bestimmung der Ausdehnungs- bzw. Dickenänderung eines elektromechanischen Elements unter Anwendung des erfindungsgemäßen Verfahrens
Fig. 2: Ausdehnungs- oder Dickenzunahme des elektromechanischen Elements gemäß Versuchsaufbau nach Fig. 1 bei Anwendung des erfindungsgemäßen Verfahrens unter Nutzung von mehreren Spannungspulsen gleicher Dauer und unterschiedlicher positiver elektrischer Spannungen
Fig. 3: Ausdehnungs- oder Dickenabnahme des elektromechanischen Elements gemäß Versuchsaufbau nach Fig. 1 bei Anwendung des erfindungsgemäßen Verfahrens unter Nutzung von mehreren Spannungspulsen gleicher Dauer und unterschiedlicher negativer elektrischer Spannungen
Fig. 4: Ausdehnungs- oder Dickenzunahme und Positionsstabilität des elektromechanischen Elements gemäß Versuchsaufbau nach Fig. 1 bei Anwendung des erfindungsgemäßen Verfahrens unter Nutzung von mehrfachen Spannungspulsen gleicher Dauer und gleicher positiver elektrischer Spannung
Fig. 5: Ausdehnungs- bzw. Dickenzunahme und Positionsstabilität des elektromechanischen Elements gemäß Versuchsaufbau nach Fig. 1 bei Anwendung des erfindungsgemäßen Verfahrens unter Nutzung von einfachen Spannungspulsen gleicher Dauer und unterschiedlicher positiver elektrischer Spannung
Fig. 6: Ausdehnungs- oder Dickenabnahme und Positionsstabilität des elektromechanischen Elements gemäß Versuchsaufbau nach Fig. 1 bei Anwendung des erfindungsgemäßen Verfahrens unter Nutzung von einfachen Spannungspulsen gleicher Dauer und unterschiedlicher negativer elektrischer Spannungen
Fig. 7: Schematische Darstellung zur Veiwendung eines nach dem erfindungsgemäßen Verfahren angesteuerten elektromechanischen Elements als Stellelement bzw. dessen entsprechende Anordnung
Fig. 8: Darstellung des zeitlichen Verlaufs der Ausdehnungsänderung eines mit einem einzelnen Spannungspuls beaufschlagten elektromechanischen Elements
Fig. 9: Darstellung des zeitlichen Verlaufs der Ausdehnungsänderung eines mit zwei aufeinanderfolgenden Spannungsimpulsen unterschiedlicher Polarität und Amplitude beaufschlagten elektromechanischen Elements

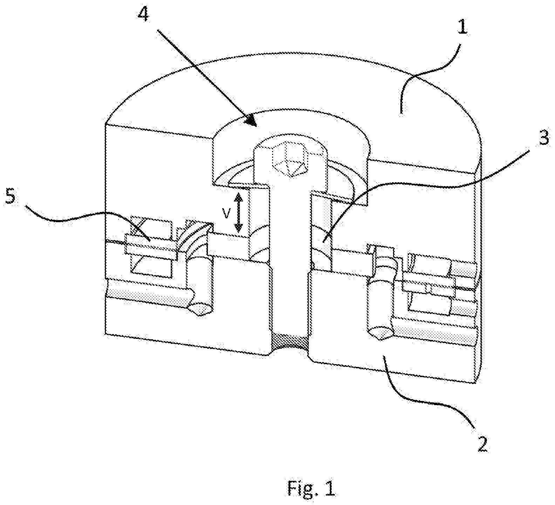

Fig. 1 zeigt den Versuchsaufbau zur Bestimmung des Ausdehnungsänderungsverhaltens eines elektromechanischen Elements entlang einer Ausdehnungsrichtung V unter Anwendung des erfindungsgemäßen Verfahrens. Der Änderungsabschnitt des elektromechanischen Elements umfasst hierbei das komplette elektromechanische Element.

Das elektromechanische Element 3 in Form eines Ringes mit einem Außendurchmesser von 16 mm, einem Innendurchmesser von 8 mm und einer Dicke von 2,5 mm besteht hierbei aus dem piezokeramischen Material PIC252 der Firma PI Ceramic GmbH, Thüringen. Dieses piezokeramische Material besitzt eine Koerzitivfeldstärke von 1,1 kV/mm. Die Ausdehnungsrichtung V entspricht der Richtung der Dickenausdehnung des elektromechanischen Elements.

Das elektromechanische Element 3 weist eine Vielzahl von Lagen piezokeramischen Materials auf, wobei die einzelnen Lagen durch dazwischen angeordnete Elektroden getrennt sind (sogenannter Multilayeraufbau), und jeweils zwischen zwei benachbarten Elektroden die entsprechende elektrische Spannung zum Ausbilden des gewünschten elektrischen Feldes innerhalb des piezokeramischen Materials anlegbar ist. Die Stapelrichtung der Lagen piezokeramischen Materials und der dazwischen angeordneten Elektroden ist hierbei in Richtung der Dickenausdahnung des elektromechanischen Elements. Die Ausdehnungsrichtung V verläuft somit im Wesentlichen senkrecht zu den Elektroden. Es ist jedoch auch denkbar, dass die Ausdehnungsrichtung V des elektromechanischen Elements parallel zu den Elektroden verläuft.

Neben dem oben beschriebenen Multilayeraufbau für das elektromechanische Element kommt auch ein Aufbau in Frage, bei welchem nur an den Außenseiten des elektromechanischen Elements Elektroden angeordnet sind, und sich dementsprechend zwischen den Elektroden nur das Material mit elektromechanischen Eigenschaften befindet.

Das elektromechanische Element 3 ist fest zwischen der Grundplatte 2 und der beweglichen Platte 1 mittels einer Vorspannungseinrichtung 4 bestehend aus einer in das Gewinde der Grundplatte eingedrehten Schraube und einer Tellerfeder, welche zwischen Schraubenkopf und beweglicher Platte angeordnet ist, eingespannt, so dass sich eine Vorspannungskraft von etwa 100N ergibt. Zwischen der Grundplatte und der beweglichen Platte ist ein kapazitives Messsystem 5 zur Erfassung ihres Abstands vorgesehen, wobei dieser Abstand mit der Ausdehnungsänderung des elektromechanischen Elements korreliert.

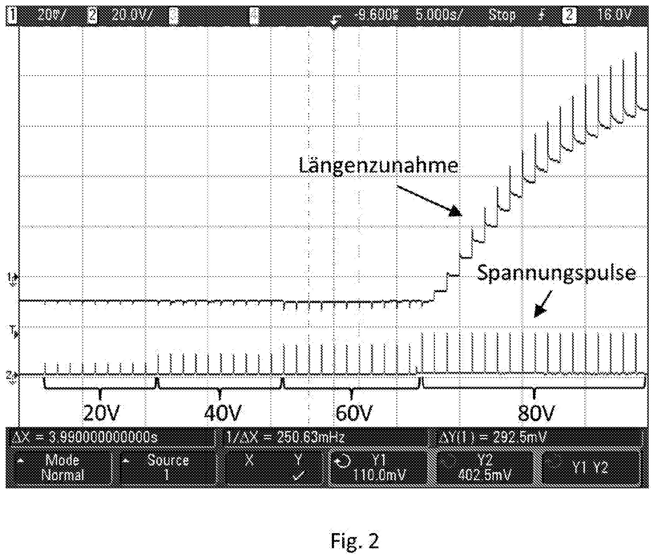

Fig. 2 zeigt mit dem Versuchsaufbau gemäß Fig. 1 erhaltene Messergebnisse an dem elektromechanischen Element, die bei Raumtemperatur ermittelt wurden. Hierbei sind zum Einen die jeweils an dem elektromechanischen Element angelegten Spannungspulse, und zum Anderen die entsprechenden Ausdehnungsänderungen des elektromechanischen Elements dargestellt. Die einzelnen Spannungspulse haben eine Dauer von 10ms, und die Frequenz der aufgebrachten Spannungspulse beträgt 1Hz.

Die bei dem labormäßigen Versuchsaufbau verwendeten Spannungspulse mit einer Dauer von 10ms sind für reale Anwendungsfälle eher nachteilig, weil die Endstufen der entsprechenden Spannungsquelle in der Regel nur begrenzte Ausgangsleistungen besitzen, und bei solch kurzen Impulszeiten sehr hohe Ströme bereitgestellt werden müssen, welche gegebenenfalls von den Endstufen nicht gewährleistet werden können. Als für reale Anwendungsfälle praktikabel haben sich Spannungspulse mit einer Dauer zwischen 50 und 150ms, bevorzugt zwischen 70 und 120ms qualifiziert, wobei die Anstiegs- und Abfallzeit an den Flanken der Spannungspulse am besten zwischen 5 und 20ms, und bevorzugt zwischen 8 und 12ms liegen.

Bei Spannungspulsen mit einer Amplitude unterhalb einer positiven elektrischen Spannung von 80 Volt erfolgt bei dem elektromechanischen Element keine erkennbare Ausdehnungs- bzw. Dickenänderung. Erst bei Spannungspulsen von +80 Volt erfolgt mit jedem einzelnen Puls eine gewisse Ausdehnungs- bzw. Dickenzunahme, die bei den anfänglichen Pulsen größer ist und mit steigender Pulsanzahl geringer wird.

In Fig. 2 ist hierbei zu erkennen, dass zu Beginn eines jeden Spannungspulses eine relativ große Ausdehnungs- bzw. Dickenänderung erfolgt, diese jedoch mit Beendigung des Spannungspulses zunächst schlagartig zurückgeht, und in direktem Anschluss über einen längeren Zeitraum nur noch ganz leicht abfällt Dieses Ausdehnungsverhalten ist darauf zurückzuführen, dass zunächst, d.h. mit Beginn des Spannungspulses, sowohl eine bleibende und eine labile Umorientierung von Domänen, als auch eine Anregung des inversen piezoelektrischen Effekts innerhalb des elektromechanischen Elements stattfindet. Effektiv nutzbar ist hierbei nur die bleibende Umorientierung der Domänen und die entsprechende remanente Ausdehnung. Der Begriff ,labile Umorientierung von Domänen' bezeichnet den Umstand, dass durch den Spannungspuls eine gewisse Anzahl von Domänen zunächst zwar eine Umorientierung erfährt, diese jedoch nicht stabil, sondern nur labil ist, so dass eine Rückorientierung in den vorherigen Zustand stattfindet. Dieser Prozess, das sogenannte Kriechen, benötigt etwas Zeit, wodurch das langsamere Abfallen der Ausdehnung in diesem Bereich zu erklären ist.

Die abzüglich des Kriechvorgangs verbleibende Ausdehnungs- bzw. Dickenzunahme beruht also auf der bleibenden bzw. dauerhaften Ausrichtung einer gewissen Anzahl von Dipolen in den einzelnen Domänen des piezokeramischen Materials des elektromechanischen Elements. Mit zunehmender Anzahl an aufgebrachten Spannungspulsen mit einer Spannung von +80 Volt erfährt das elektromechanische Element eine zunehmende Polarisation, wobei diese Polarisation eine bleibende bzw. remanente Dehnung hervorruft, welche auch nach Wegnahme der elektrischen Spannung bestehen bleibt.

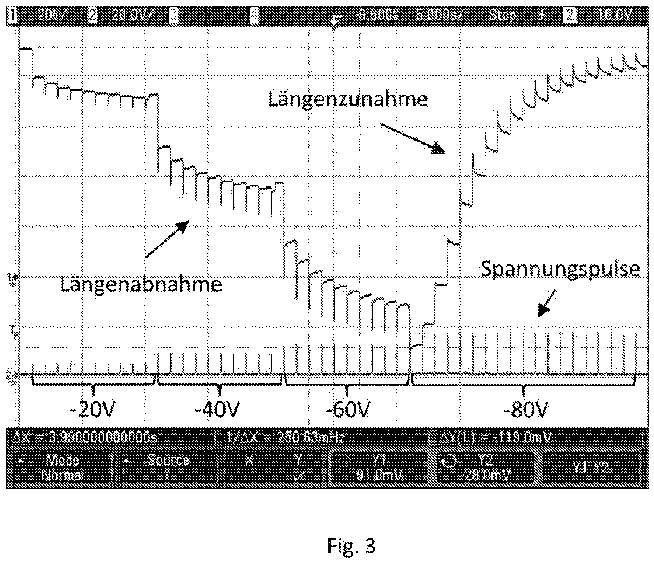

Fig. 3 zeigt weitere mit dem Versuchsaufbau gemäß Fig. 1 erhaltene Messergebnisse an dem elektromechanischen Element bei Raumtemperatur, und zwar nach Durchführung der Messungen gemäß Fig. 2. Ausgangszustand ist dementsprechend ein bereits in der Ausdehnung entlang der Ausdehnungsrichtung V bzw. in Dickenrichtung vergrößerten elektromechanischen Elements, an welches in einem ersten Schritt Pulse mit einer geringen negativen elektrischen Spannung von -20 Volt angelegt werden. Bereits diese niedrige elektrische Spannung reicht dabei aus, dass die einzelnen Pulse eine Ausdehnungs- bzw. Dickenreduktion des elektromechanischen Elements bewirken, welche mit den anfänglichen Pulsen stärker ausfällt als bei den nachfolgenden Pulsen. Diese Ausdehnungs- bzw. Dickenreduktion beruht auf einer teilweisen Depolarisation des piezokeramischen Materials des elektromechanischen Elements, so dass in den einzelnen Domänen bereits ausgerichtete Dipole in einen nicht-ausgerichteten Zustand überführt werden.

Wird die negative elektrische Spannung weiter auf -40 Volt verändert, erfolgt mit jedem entsprechenden Puls eine größere Ausdehnungs- oder Dickenreduktion bzw. Depolarisation, die anfänglich deutlich stärker ist. Bei weiterer Änderung der negativen elektrischen Spannung auf -60 Volt ergibt sich abermals eine erhöhte Ausdehnungs- oder Dickenreduktion im Vergleich zu den beiden zuvor angewandten Spannungspulsen. Wird die Spannung auf -80 Volt eingestellt, findet in den Domänen des piezokeramischen Materials des elektromechanischen Elements eine sogenannte Umpolarisation statt, bei welcher eine spontane Ausrichtung der Dipole in einer Richtung resultiert, welche entgegengesetzt zu der Ausrichtungsrichtung bei der vorhergehenden Depolarisation ist. Die Pulse mit einer negativen elektrischen Spannung von -80 Volt bewirken dabei aufeinanderfolgende Schritte der Ausdehnungs- bzw. Dickenzunahme, die ähnlich zu den Schritten der Ausdehnungs- bzw. Dickenzunahme bei der Anwendung der Pulse mit einer positiven elektrischen Spannung von +80 Volt sind.

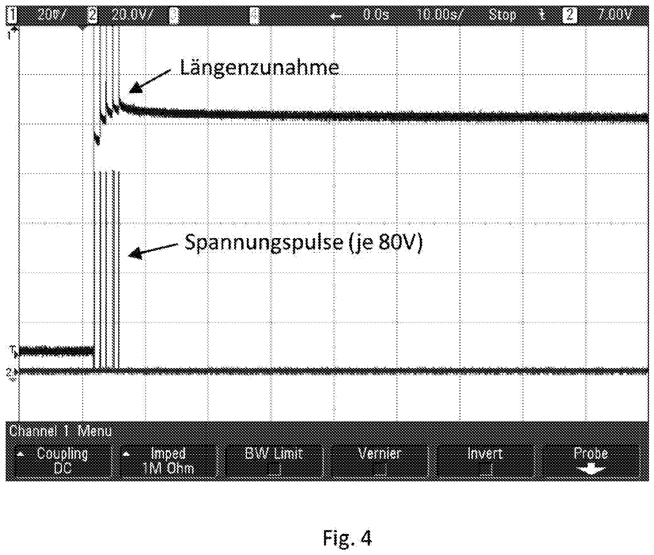

Fig. 4 zeigt Messergebnisse an einem elektromechanischen Element gemäß dem Versuchsaufbau in Fig. 1, wobei exakt fünf Spannungspulse mit einer jeweiligen Pulsdauer von 10 ms, einer Pulsfrequenz von 1 Hz und einer elektrischen Spannung von +80 Volt bei Raumtemperatur auf das elektromechanische Element aufgebracht werden, und danach die Spannungsquelle von dem elektromechanischen Element getrennt wird. Nach besagter Trennung der Spannungsquelle von dem elektromechanischen Element behält dieses die entsprechend induzierte Ausdehnungs- bzw. Dickenzunahme aufgrund der korrespondierenden Polarisation dauerhaft und stabil bei.

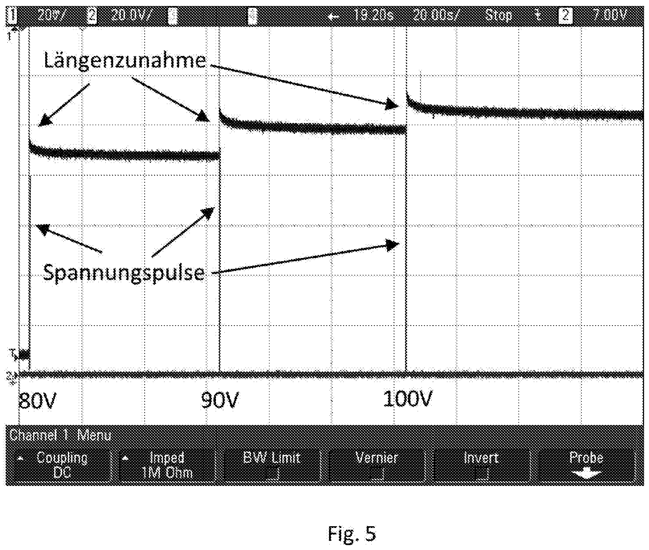

In Fig. 5 sind Messergebnisse gezeigt, die ebenfalls an einem elektromechanischen Element gemäß dem Versuchsaufbau in Fig. 1 bei Raumtemperatur ermittelt wurden. Hierbei werden nacheinander drei einzelne Pulse mit einer Pulsdauer von jeweils 10 ms mit unterschiedlich hohen positiven elektrischen Spannungen auf das elektromechanische Element aufgebracht mit nachfolgender Wegnahme der jeweiligen elektrischen Spannung. Nach dem ersten Spannungspuls mit einer Amplitude von +80 Volt ergibt sich eine bestimmte Ausdehnungs- oder Dickenzunahme bzw. Polarisation, die nach Wegnahme der elektrischen Spannung bestehen bleibt (remanente Dehnung), Bei dem nachfolgenden zweiten Spannungspuls mit einer Amplitude von +90 Volt ergibt sich eine Ausdehnungs-oder Dickenzunahme, die größer ist als bei dem ersten Spannungspuls. Auch diese Ausdehnungs- oder Dickenzunahme bleibt nach Wegnahme der elektrischen Spannung bestehen. Beim dritten Spannungspuls mit einer Amplitude von +100 Volt schließlich ergibt sich die größte Ausdehnungs- oder Dickenzunahme, wobei jedoch der Unterschied zu der Ausdehnungszunahme bei +90 Volt geringer ausfällt als der entsprechende Unterschied zwischen +80 Volt und +90 Volt. Auch nach Wegnahme der Spannung von +100 Volt bleibt die korrespondierende Dehnung remanent.

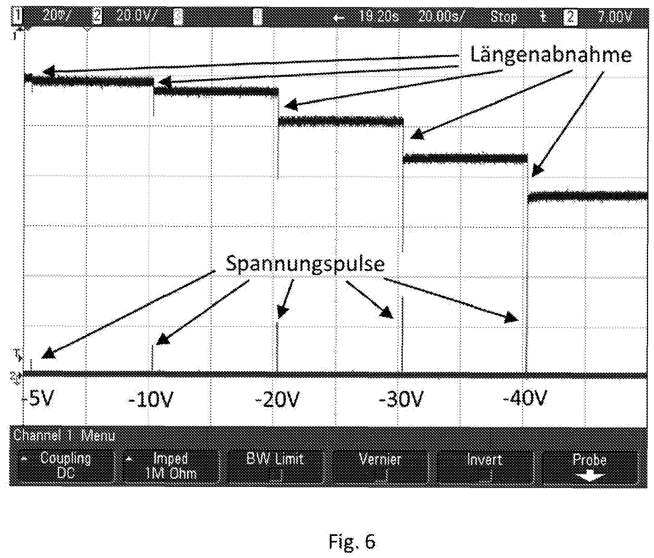

Direkt im Anschluss an die Ermittlung der Messergebnisse gemäß Fig. 5 wurden an das gleiche elektromechanische Element bei Raumtemperatur und ebenfalls unter Nutzung des Versuchsaufbaus gemäß Fig. 1 Pulse mit unterschiedlichen negativen elektrischen Spannungen angelegt mit nachfolgender Wegnahme (siehe Fig. 6). Bereits bei der sehr niedrigen Spannung von -5 Volt resultiert. eine geringfügige Depolarisation mit entsprechender Ausdehnungs- bzw. Dickenreduktion des elektromechanischen Elements, wobei die resultierende Ausdehnungs- oder Dickenänderung bleibend bzw. remanent ist. Dies zeigt sich in analoger Weise für die nachfolgenden Spannungspulse mit Amplituden von -10 Volt, -20 Volt, -30 Volt und -40 Volt. In jedem Falle ergibt sich eine bleibende bzw. remanente Ausdehnungsreduktion bzw. Dickenreduktion des elektromechanischen Elements, wobei die jeweilige Reduktion umso größer ist, je höher die negative Spannung ist. Dieser Effekt ist besonders deutlich bei den ersten vier Spannungspulsen, während der Unterschied in der Ausdehnungsänderung bei -30 Volt und -40 Volt nur noch marginal ist.

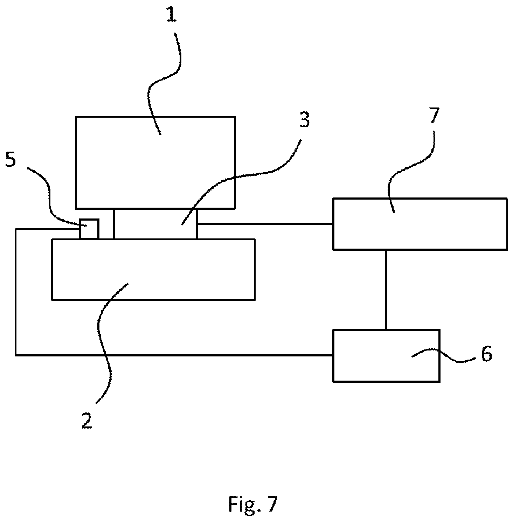

Fig. 7 verdeutlicht in einer schematischen Darstellung zum Einen die Verwendung eines nach dem erfindungsgemäßen Verfahren angesteuerten elektromechanischen Elements als Stellelement, und zum Anderen die entsprechende Anordnung eines solchen elektromechanischen Elements. Wie in Fig.1 stellt das gesamte elektromechanische Element den Änderungsabschnitt des elektromechanischen Elements dar.

Das elektromechanische Element bzw. das Stellelement 3 ist hierbei zwischen einem ortsfesten Element in Form der Grundplatte 2 und einem gegenüber der Grundplatte 2 zu bewegenden Element in Form der beweglichen Platte 1 angeordnet, wobei mittels eines kapazitiven Messsystems 5 der Abstand zwischen der Grundplatte 2 und der beweglichen Platte 1 gemessen bzw. kontrolliert wird. Die so ermittelten Abstandsdaten werden einem Controller 6 übergeben, der entsprechende Ansteuersignale an die Spannungsquelle 7 sendet, und die Spannungsquelle 7, die elektrisch mit dem Stellelement 3 verbunden ist, beaufschlagt dieses mit entweder mit einer Folge von Spannungspulsen oder aber nur mit einem einzelnen Spannungspuls, so dass die gewünschte Position der beweglichen Platte 1 aufgrund einer definierten Zunahme oder Abnahme der Ausdehnung des Stellelements in einer Ausdehnungsrichtung V, welche parallel zur Verstellrichtung der beweglichen Platte 1 verläuft, angefahren wird. Sodann erfolgt eine Trennung der elektrischen Verbindung zwischen der Spannungsquelle 7 und dem Stellelement 3, wobei das Stellelement 3 seine zuvor eingestellte und definierte Ausdehnungsänderung auch ohne elektrische Spannungsbeaufschlagung dauerhaft beibehält.

Neben der so beschriebenen Verwendung eines nach dem erfindungsgemäßen Verfahren angesteuerten elektromechanischen Elements als Stellelement in einem geregelten System, d.h. unter Zuhilfenahme eines Messsystems und die Übergabe der entsprechenden Messwerte an einen Controller, ist auch eine Verwendung als Stellelement in einem ungeregelten System {open loop) möglich. Diesbezügliche Versuche der Anmelderin haben gezeigt, dass hierbei Genauigkeiten von etwa+/- 3% erzielbar sind, wobei durch Optimierung auch höhere Genauigkeiten möglich erscheinen.

Die Verwendung eines nach dem erfindungsgemäßen Verfahren angesteuerten elektromechanischen Elements als Stellelement erlaubt hierbei Stellbewegungen mit geringsten Dimensionen, wobei die Dimension der Stellbewegungen insbesondere von der Höhe bzw. der Amplitude und der Dauer der Spannungspulse abhängen.

Es ist weiterhin eine Anordnung, insbesondere eine Reihenanordnung, eines mit dem erfindungsgemäßen Verfahren angesteuerten elektromechanischen Elements zusammen mit einem herkömmlichen elektromechanischen Element wie etwa einem piezoelektrischen Aktor oder Piezoaktor denkbar, wobei der herkömmliche Piezoaktor die entsprechende Ausdehnung nur solange aufrecht erhält, wie eine elektrische Spannung an diesem anliegt, während bei dem nach dem erfindungsgemäßen Verfahren angesteuerten elektromechanischen Element die Ausdehnungszunahme oder -abnahme auch ohne Anliegen einer elektrischen Spannung gewährleistet Ist. Der vorstehend bezeichnete Begriff ,Reihenanordnung' beschreibt hierbei eine Anordnung, bei welchem das elektromechanische Element und der herkömmliche Piezoaktor hintereinander angeordnet sind, so dass der herkömmliche Piezoaktor zwischen dem elektromechanischen Element und einem der gegeneinander zu bewegenden Elemente angeordnet ist.

Neben der zuvor beschriebenen Reihenanordnung von elektromechanischem Element und herkömmlichem Piezoelement sieht die Erfindung vor, dass ein einziges elektromechanisches Element vorhanden ist, bei welchem ein Abschnitt, nämlich der Änderungsabschnitt, nach dem erfindungsgemäßen Verfahren angesteuert ist, während der verbleibende Teil oder Abschnitt des elektromechanischen Elements entweder einen gleichen oder einen anderen Aufbau wie der Änderungsabschnitt aufweist, und dieser verbleibende Teil oder Abschnitt des elektromechanischen Elements nach einem herkömmlichen Verfahren zur Ansteuerung eines elektromechanischen Elements angesteuert ist. Beispielsweise handelt es sich bei dem verbleibenden Teil oder Abschnitt des elektromechanischen Elements um ein piezoelektrisches Material mit wenigstens zwei Elektroden, zwischen welchen dieses piezoelektrische Material angeordnet ist, wobei das piezoelektrische Material vollständig polarisiert ist, und eine zur angelegten Spannung korrelierende Ausdehnung realisiert werden kann, die allerdings mit Wegnahme der elektrischen Spannung - im Gegensatz zu einer Ausdehnungsänderung des Änderungsabschnitts - wieder auf den ursprünglichen Wert zurückfällt. Somit stellt der verbleibende Teil oder Abschnitt des elektromechanischen Materials einen herkömmlichen Piezoaktor dar.

Die maximal mögliche, durch Anlegen einer elektrischen Spannung hervorgerufene Ausdehnung eines herkömmlichen Piezoaktors beträgt etwa 1-2 %o seiner Abmessung in Ausdehnungsrichtung ohne angelegte elektrische Spannung. Dagegen beträgt die maximal mögliche, ohne die Einwirkung einer elektrischen Spannung dauerhaft bestehende Ausdehnung in Ausdehnungsrichtung eines nach dem erfindungsgemäßen Verfahrens angesteuerten elektromechanischen Elements etwa 50-60% der maximal möglichen Ausdehnung eines herkömmlichen Piezoaktors (bei gleichem Aufbau von elektromechanischem Element und herkömmlichem Piezoaktor).

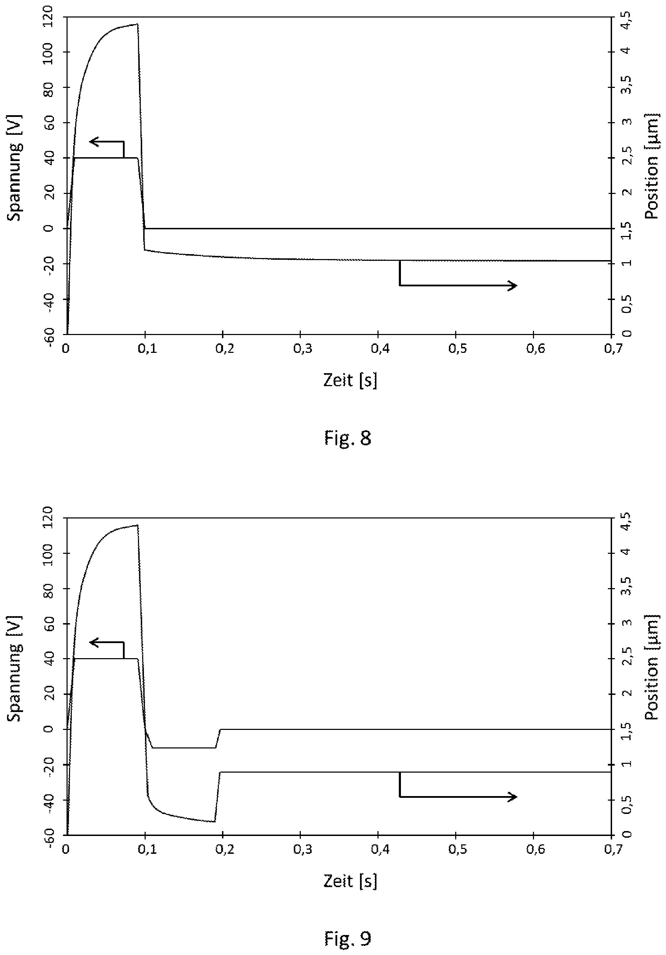

Fig. 8 verdeutlicht in einem Messdiagramm den zeitlichen Verlauf der Ausdehnungsänderung eines mit einem einzelnen Spannungspuls beaufschlagten elektromechanischen Elements gemäß Versuchsanordnung von Fig. 1. Der Spannungspuls hat dabei eine Amplitude von 40 Volt und eine Dauer von 100ms, wobei die Anstiegszeit und die Abfallzeit der Flanken des Pulses eine Dauer von etwa 10ms besitzen. Mit Einsetzen des Spannungspulses erfolgt eine rasche Ausdehnungsvergrößerung des elektromechanischen Elements um fast 4,5 µm. Diese Ausdehnungsvergrößerung nimmt schlagartig mit Beendigung des Spannungspulses ab, wobei gegenüber dem Ausgangszustand eine remanente Dehnung von ca. 1,2 µm verbleibt. Im weiteren Verlauf ist zu erkennen, dass die remanente Dehnung direkt nach Beendigung des Spannungspulses noch nicht konstant ist, sondern über einen gewissen Zeitraum noch ein geringfügiger Rückgang der Ausdehnung stattfindet Dies ist darauf zurückzuführen, dass durch den Spannungspuls bei einigen Domänen zwar eine Umorientierung stattfand, wobei die eingebrachte Energie jedoch nicht für eine dauerhafte und bleibende Umorientierung ausreichend ist. Es finden Rückklappvorgänge statt, wodurch die zuvor realisierte Umorientierung der entsprechenden Domänen wieder rückgängig gemacht wird (Kriechvorgang oder Kriechen). Insgesamt resultiert dadurch mit dem einzelnen Spannungspuls eine etwas reduzierte Ausdehnungsänderung.

Um dem vorstehend beschriebenen Phänomen des Kriechens zu begegnen, besteht die Möglichkeit, direkt im Anschluss des ersten Spannungspulses einen zweiten Spannungspuls zu applizieren, wobei der zweite Spannungspuls jedoch eine umgekehrte Polarität wie der erste Spannungspuls aufweist. Fig. 9 verdeutlicht die durch den zweiten Spannungspuls oder Gegenpuls erzielbaren Effekte anhand eines Messdiagramms, wobei ansonsten im Vergleich zu Fig. 8 identische Messbedingungen vorlagen.

Der Fig. 9 ist zu entnehmen, dass mit dem ersten Spannungspuls positiver Polarität ein Ausdehnungsverhalten bezüglich des elektromechanischen Elements erzielt wird wie es bereits aus Fig. 8 bekannt ist. Durch den sich anschließenden zweiten Spannungspuls mit negativer Polarität und gleicher Dauer, aber geringerer Amplitude als beim ersten Spannungspuls erfolgt abweichend zu Fig. 8 eine gewisse Depolarisation des zuvor polarisierten Materials des elektromechanischen Elements, wobei diese Depolarisation jedoch gering ist und im Wesentlichen dafür sorgt, dass die zu Fig. 8 beschriebenen Rückklappvorgänge erheblich beschleunigt werden, so dass keine Kriechvorgänge mehr an dem elektromechanischen Element zu messen sind. Letztlich wird die remanente Dehnung des elektromechanischen Elements im Vergleich zu der ansonsten identischen Messung gemäß Fig. 8 durch den Gegenpuls nur geringfügig reduziert, jedoch mit dem entscheidenden Vorteil, dass die remanente Dehnung nun keine zeitabhängige Änderung mehr erfährt und stabil ist.

Es sei explizit darauf hingewiesen, dass das erfindungsgemäße Verfahren sowohl die Anwendung einer Folge von Spannungspulsen, als auch die Anwendung eines einzelnen bzw. einzigen Spannungspulses zur Erreichung einer gewünschten Ausdehnung des elektromechanischen Elements vorsieht.

## Patentansprüche

1. Verfahren zur Ansteuerung wenigstens eines Abschnitts eines elektromechanischen Elements, wobei der entsprechende Abschnitt einen Änderungsabschnitt definiert, umfassend folgende Schritte:
Bereitstellen eines elektromechanischen Elements als Stellelement, wobei bei dem elektromechanischen Element zumindest der Änderungsabschnitt wenigstens zwei voneinander beabstandete Elektroden und ein zwischen den Elektroden angeordnetes polykristallines und ferroelektrisches oder ferroelektrisch-piezoelektrisches Material mit einer Vielzahl von Domänen aufweist, wobei in einem Ausgangszustand zumindest ein Teil der Domänen voneinander abweichende Polarisationsrichtungen aufweist,
Erzeugung eines elektrischen Feldes zwischen den Elektroden des Änderungsabschnitts durch Anlegen einer elektrischen Spannung in Form wenigstens eines Spannungspulses mit einer definierten Amplitude und einer definierten Dauer und bleibende Änderung des Polarisationsgrads des Änderungsabschnitts in Abhängigkeit der Amplitude und der Dauer des Spannungspulses für eine kontrollierte bleibende Ausdehnungsänderung des Änderungsabschnitts des Stellelements mit:
Überführen eines Teils der Domänen mit voneinander abweichenden Polarisationsrichtungen in einen Zustand gleicher Polarisationsrichtung aufgrund des wenigstens einen Spannungspulses und dadurch Erzeugen einer definierten und ohne das Vorhandensein einer elektrischen Spannung verbleibenden Zunahme der Ausdehnung des Änderungsabschnitts des elektromechanischen Elements entlang einer Ausdehnungsrichtung V oder
Überführen eines Teils der Domänen mit gleicher Polarisationsrichtung in einen Zustand mit voneinander abweichenden Polarisationsrichtungen aufgrund des wenigstens einen Spannungspulses und dadurch Erzeugen einer definierten und ohne das Vorhandensein einer elektrischen Spannung verbleibenden Abnahme der Ausdehnung des Änderungsabschnitts des elektromechanischen Elements entlang der Ausdehnungsrichtung V.

2. Verfahren nach Anspruch 1, wobei die Dauer eines Spannungspulses zwischen 50 und 150ms, und bevorzugt zwischen 70 und 120ms beträgt.

3. Verfahren nach einem der vorhergehenden Ansprüche, wobei nach dem Schritt des Bereitstellens eines elektromechanischen Elements und vor dem Schritt der Erzeugung eines elektrischen Feldes zwischen den Elektroden des Änderungsabschnitts durch Anlegen einer elektrischen Spannung in Form wenigstens eines Spannungspulses ein zusätzlicher Verfahrensschritt zur Erzeugung einer definierten Anfangsausdehnung des Änderungsabschnitts ausgeführt wird, bei welchem eine solche elektrische Spannung bzw. solche elektrische Spannungen an die Elektroden des Änderungsabschnitts angelegt wird bzw. werden, wonach eine maximale Ausdehnungszunahme entsprechend einem Polarisationsgrad von 100% und/oder eine maximale Ausdehnungsabnahme entsprechend einem Polarisationsgrad von 0% des Änderungsabschnitts resultieren/resultiert, wobei der Unterschied zwischen der maximalen Ausdehnungszunahme und der maximalen Ausdehnungsabnahme den maximal möglichen Ausdehnungsänderungsbereich definiert.

4. Verfahren nach Anspruch 3, wobei bei einer beabsichtigen Ausdehnungsänderung von weniger als 50% des maximalen Ausdehnungsänderungsbereichs eine solche elektrische Spannung an die Elektroden des Änderungsabschnitts angelegt wird, dass ein Polarisationsgrad von 0% resultiert, und bei einer beabsichtigten Ausdehnungsänderung von mehr als 50% des maximalen Ausdehnungsänderungsbereichs eine solche elektrische Spannung an die Elektroden des Änderungsabschnitts angelegt wird, dass ein Polarisationsgrad von 100% resultiert.

5. Verfahren nach Anspruch 1 oder 2, wobei die Bereitstellung eines elektromechanischen Elements, bei welchem in dem Ausgangszustand der Polarisationsgrad des Materials des Änderungsabschnitts des elektromechanischen Elements zwischen 40% und 60%, und besonders bevorzugt 50% beträgt, vorgesehen ist.

6. Verfahren nach einem der vorhergehenden Ansprüche, wobei die Amplitude des wenigstens einen Spannungspulses für eine definierte Zunahme der Ausdehnung des Änderungsabschnitts des elektromechanischen Elements entlang der Ausdehnungsrichtung V so bemessen ist, dass eine resultierende elektrische Feldstärke zwischen benachbarten Elektroden zwischen 50% und 200% der Koerzitivfeldstärke beträgt.

7. Verfahren nach einem der vorhergehenden Ansprüche, wobei die Amplitude des wenigstens einen Spannungspulses für eine beabsichtigte Verkürzung des Stellelements so bemessen ist, dass die resultierende elektrische Feldstärke zwischen benachbarten Elektroden zwischen 10 % und 90 % der Koerzitivfeldstärke beträgt.

8. Verfahren nach einem der vorhergehenden Ansprüche, wobei einem ersten Spannungspuls ein zweiter Spannungspuls folgt, wobei der zweite Spannungspuls eine zu dem ersten Spannungspuls unterschiedliche Polarität aufweist.

9. Verfahren nach Anspruch 8, wobei sich die Amplitude des zweiten Spannungspulses von der Amplitude des ersten Spannungspulses unterscheidet.

10. Verfahren nach Anspruch 9, wobei die Amplitude des zweiten Spannungspulses betragsmäßig kleiner als die Amplitude des ersten Spannungspulses ist.

## Claims

1. Method for controlling at least one section of an electromechanical element, wherein the corresponding section defines a change section, comprising the following steps:
providing an electromechanical element as adjustment element, wherein with the electromechanical element at least the change section comprises at least two electrodes spaced apart from each other and a polycrystalline and ferroelectric or
ferroelectric-piezoelectric material with a plurality of domains disposed between the electrodes, wherein in an initial state at least a part of the domains comprises polarization directions which differ from each other;
generating an electric field between the electrodes of the change section by applying an electrical voltage in the form of at least one voltage pulse with a defined amplitude and a defined duration and permanent change in the degree of polarization of the change section depending on the amplitude and duration of the voltage pulse for a controlled permanent change in expansion of the change section of the adjustment element with:
transferring a part of the domains with polarization directions which diverge from each other into a state with the same polarization direction due to the at least one voltage pulse and thereby generating a defined and without the presence of electrical voltage remaining increase in the extension of the change section of the electromechanical element along a direction of extension V, or
transferring a part of the domains with the same polarization directions into a state with polarization directions which diverge from each due to the at least one voltage pulse and thereby generating a defined and without the presence of electrical voltage remaining decrease in the extension of the change section of the electromechanical element along a direction of extension V.

2. Method according to claim 1, wherein the duration of a voltage pulse is between 50 and 150 ms, and preferably between 70 and 120 ms.

3. Method according to one of the preceding claims, wherein after the step of providing an electromechanical element and before the step of generating an electric field between the electrodes of the change section by applying an electrical voltage in the form of at least one voltage pulse, an additional method step for generating a defined initial extension of the change section is performed, in which such electrical voltage or such electrical voltages are applied to the electrodes of the change section, by which a maximum extension increase corresponding to a degree of polarization of 100% and/or a maximum extension decrease corresponding to a polarization degree of 0% of the change section results or result, wherein the difference between the maximum extension increase and the maximum extension decrease defines the maximum possible extension change range.

4. A method according to claim 3, wherein with an intended extension change of less than 50% of the maximum extension change range, such voltage is applied to the electrodes of the change section which results in a degree of polarization of 0%, and with an intended extension change of more than 50% of the maximum extension change range, such an electric voltage is applied to the electrodes of the change section which results in a degree of polarization of 100%.

5. Method according to claim 1 or 2, wherein an electromechanical element is provided which, in the initial state, comprises a degree of polarization of the material of the change section of the electromechanical element which is between 40% and 60%, and particularly preferably 50%.

6. Method according to one of the preceding claims, wherein the amplitude of the at least one voltage pulse for a defined increase in the extension of the change section of the electromechanical element along the extension direction V is dimensioned such that a resulting electric field strength between adjacent electrodes is between 50% and 200% of the coercive field strength.

7. Method according to one of the preceding claims, wherein the amplitude of the at least one voltage pulse for a defined decrease in the extension of the change section of the electromechanical element is dimensioned such that the resulting electric field strength between adjacent electrodes is between 10% and 90% of the coercive field strength.

8. Method according to one of the preceding claims, wherein a second voltage pulse follows a first voltage pulse, wherein the second voltage pulse has a polarity different from the first voltage pulse.

9. Method according to claim 8, wherein the amplitude of the second voltage pulse differs from the amplitude of the first voltage pulse.

10. Method according to claim 9, wherein the amplitude of the second voltage pulse is smaller in magnitude than the amplitude of the first voltage pulse.

## Revendications

1. Procédé, destiné à actionner au moins une section d'un élément électromécanique, la section en question définissant une section de modification, comprenant les étapes suivantes, consistant à :
mettre à disposition un élément électromécanique, en tant qu'élément de réglage, sur l'élément électromécanique, au moins la section de modification comportant au moins deux électrodes écartées l'une de l'autre et une matière polycristalline et ferroélectrique ou piézoélectrique et ferroélectrique, placée entre les électrodes, comprenant une pluralité de domaines, dans un état initial, au moins une partie des domaines présentant des directions de polarisation divergentes les unes des autres,
générer un champ électrique entre les électrodes de la section de modification en appliquant une tension électrique sous la forme d'au moins une impulsion de tension d'une amplitude définie et d'une durée définie et modifier de manière permanente le degré de polarisation de la section de modification en fonction de l'amplitude et de la durée de l'impulsion de tension pour une modification permanente contrôlée de la dilatation de la section de modification de l'élément de réglage, comprenant :
le passage d'une partie des domaines présentant des directions de polarisation divergentes les unes des autres dans un état de direction de polarisation identique, du fait de l'au moins une impulsion de tension et ainsi, la génération d'une augmentation définie et permanente, sans la présence d'une tension électrique de la dilatation de la section de modification de l'élément électromécanique le long d'une direction de dilatation V ou
le passage d'une partie des domaines présentant des directions de polarisation identiques dans un état de directions de polarisation différentes, du fait de l'au moins une impulsion de tension et ainsi la génération d'une diminution définie et permanente, sans la présence d'une tension électrique de la dilatation de la section de modification de l'élément électromécanique le long d'une direction de dilatation V.

2. Procédé selon la revendication 1, la durée d'une impulsion de tension étant comprise entre 50 et 150 ms, et de préférence entre 70 et 120 ms.

3. Procédé selon l'une quelconque des revendications précédentes, après l'étape consistant à mettre à disposition un élément électromécanique et avant l'étape consistant à générer un champ électrique, une étape de procédé additionnelle étant réalisée entre les électrodes de la section de modification, par application d'une tension électrique sous la forme d'au moins une impulsion de tension, pour générer une dilatation initiale définie de la section de modification, lors de laquelle une telle tension électrique ou de telles tensions électrique est ou sont appliquée(s) sur les électrodes de la section de modification, de quoi résulte/résultent une augmentation maximale de la dilatation correspondant à un degré de polarisation de 100 % et/ou une diminution maximale de la dilatation correspondant à un degré de polarisation de 0 % de la section de modification, la différence entre l'augmentation maximale de la dilatation et la diminution maximale de la dilatation définissant la plage maximale possible de modification de la dilatation.

4. Procédé selon la revendication 3, pour une modification prévue de la dilatation de moins de 50 % de la plage maximale de modification de la dilatation, une tension électrique telle étant appliquée sur les électrodes de la section de modification, qu'il en résulte un degré de polarisation de 0 %, et pour une modification prévue de la dilatation de plus de 50 % de la plage maximale de modification de la dilatation, une tension électrique telle étant appliquée sur les électrodes de la section de modification, qu'il en résulte un degré de polarisation 100%.

5. Procédé selon la revendication 1 ou 2, la mise à disposition d'un élément électromécanique étant prévue sur lequel, dans l'état initial, le degré de polarisation de la matière de la section de modification de l'élément électromécanique se situe entre 40 % et 60 %, et de manière particulièrement préférentielle, est de 50 %.

6. Procédé selon l'une quelconque des revendications précédentes, l'amplitude de l'au moins une impulsion de tension pour une augmentation définie de la dilatation de la section de modification de l'élément électromécanique le long de la direction de dilatation V étant dimensionnée de telle sorte qu'une intensité de champ électrique résultante entre des électrodes voisines soit comprise entre 50 % et 200 % de l'intensité du champ coercitif.

7. Procédé selon l'une quelconque des revendications précédentes, l'amplitude de l'au moins une impulsion de tension pour un raccourcissement prévu de l'élément de réglage étant dimensionnée de telle sorte que l'intensité de champ électrique résultante entre des électrodes voisines soit comprise entre 10 % et 90 % de l'intensité du champ coercitif.

8. Procédé selon l'une quelconque des revendications précédentes, à une première impulsion de tension faisant suite une deuxième impulsion de tension, la deuxième impulsion de tension faisant preuve d'une polarité différente de celle de la première impulsion de tension.

9. Procédé selon la revendication 8, l'amplitude de la deuxième impulsion de tension étant différente de l'amplitude de la première impulsion de tension.

10. Procédé selon la revendication 9, l'amplitude de la deuxième impulsion de tension étant inférieure au niveau de sa valeur de l'amplitude de la première impulsion de tension.
